**Europäisches Patentamt**

(19) **European Patent Office**

**Office européen des brevets**

(11) Veröffentlichungsnummer: **0 120 196**
**B1**

(12) # EUROPÄISCHE PATENTSCHRIFT

(45) Veröffentlichungstag der Patentschrift:
04.11.87

(51) Int. Cl.⁴: **G 01 D 3/10, B 60 R 16/02**

(21) Anmeldenummer: **84100471.6**

(22) Anmeldetag: **18.01.84**

(54) **Schaltungsanordnung zur optischen Anzeige von Zustandsgrössen.**

(30) Priorität: **18.02.83 DE 3305579**

(43) Veröffentlichungstag der Anmeldung:
**03.10.84 Patentblatt 84/40**

(45) Bekanntmachung des Hinweises auf die Patenterteilung:
**04.11.87 Patentblatt 87/45**

(84) Benannte Vertragsstaaten:
**DE FR GB IT SE**

(56) Entgegenhaltungen:
**DE-A-2 724 759**

**ELEKTRONIK-REPORT 6, Juni 1980, WIEN; DANCE:
"Salplex ersetzt den Kabelbaum" Seiten 33, 34
INTERNATIONALE ELEKTRONISCHE RUNDSCHAU
12-1975; HOMBURG: "Multiplexsystem als
Kabelbaumersatz im Kraftfahrzeug", Seiten 277, 278**

(73) Patentinhaber: **ROBERT BOSCH GMBH, Postfach
50, D-7000 Stuttgart 1 (DE)**

(72) Erfinder: **Haubner, Georg, Ludwigstrasse 1, D-8431
Berg (DE)**
Erfinder: **Petermann, Hans, Klintstrasse 6c, D-8500
Nürnberg (DE)**
Erfinder: **Zöbl, Hartmut, Moststrasse 25, D-8510
Fürth (DE)**

EP 0 120 196 B1

# 0 120 196

2

**Beschreibung**

**Stand der Technik**

Die Erfindung geht aus von einer Schaltungsanordnung zur optischen Anzeige von zustandsgrößen im Kraftfahrzeug nach dem ersten Teil des unabhängigen Anspruchs. Bei einer bekannten Schaltungsanordnung werden von einem Ringzähler verschiedene Sensoren zyklisch abgefragt, die bestimmte Zustandsgrößen im Kraftfahrzeug messen und als elektrische Meßwerte ausgeben. Die gemessenen Werte können über eine Logikschaltung als elektrische Signale in zeitlicher Folge an einer Anzeige ausgegeben und bei Defekten über verschiedene Leuchtdioden angezeigt werden. Dadurch wird der Zustand der einzelnen, von den sensoren überwachten Einrichtungen optisch angezeigt (DE-A-25 55 828, Figur 2). Diese Lösung hat vor allem den Nachteil, daß für jede Leuchtdiode eine Steuerleitung zu der zentral angeordneten Logikschaltung geführt werden muß. Außerdem können bei dieser Schaltungsanordnung nur Zustandegrößen erfaßt werden, die eine Ein- oder Austellung signalisieren. Kontinuierlich veränderliche Zustandsgrößen wie beispielsweise Fahrgeschwindigkeit, Tankfüllung und dgl. können mit dieser Schaltungsanordnung nicht genau genug angezeigt werden. Ferner muß bei einem Defekt in der Schaltungsanordnung die komplette Logikschaltung bzw. das komplette Schaltgerät ausgewechselt werden.

Eine Schaltungsanordnung nach dem ersten Teil des unabhängigen Anspruchs ist aus der Zeitschrift Elektronik-Report 6, Juni 1880, Seiten 33 bis 34 bekannt. Die darin als "Salplex" bezeichnete Schaltungsanordnung ist unter anderem zur Anzeige von Zustandsgrößen in Kraftfahrzeugen zu verwenden und weist eine ringförmige Informationsleitung sowie eine vielzahl von Dekodier/Empfänger- und Kodier/-Geber-Einheiten auf. Dort wird für jede von einer Geber-Einheit auf eine Empfänger-Einheit zu übertragene einzelne Information ein aue 10-Bit bestehendes Datenwort erzeugt, welches 5 Bits als Empfangsadresse, 3 weitere Bits als Kanalerkennung und lediglich 1 Bit für die Information selbst enthält. Eine solche Lösung ist für die Übertragung von Meßwerten, die sich laufend ändern, ungeeignet, da für jeden analogen oder digitalen Meßwert mehrere Datenwörter benötigt werden, so daß bei der Übertragung mehrerer Meßwerte soviel Zeit benötigt wird, daß eine solche Anzeige zu träge ist. Außerdem muß jeder Geber mit einer relativ aufwendigen eigenen Kodierlogik ausgerüstet werden.

Aus der Zeitschrift "Internationale Elektronische Rundschau" 12, 1975, Seiten 277 bis 278, ist eine Schaltungsanordnung zur Übertragung von in Datenwörtern mit Adresskode festgelegten Informationen bekannt, wobei die Datenwörter in einer zyklischen Folge auf der Datenleitung gesendet werden.

Mit der vorliegenden Lösung wird angestrebt, möglichst viele durch Sensoren digital und analog zu messende Zustandsgrößen im Kraftfahrzeug in einer Steuerlogik zusammenzufassen und als serielle digitale Signalfolge mit möglichst hoher Informationsdichte über eine Steuerleitung an dezentrale Steuermodule mit daran angeschlossenen Anzeigeelementen weiterzuleiten.

**Vorteile der Erfindung**

Die erfindungsgemäße Schaltungsanordnung mit den kennzeichnenden Merkmalen des unabhängigen Anspruchs hat den Vorteil, daß beim Auftreten von Fehlern die zentrale Steuerlogik und die dezentralen Steuermodule voneinander getrennt überprüft und gegebenenfalle getrennt ausgewechselt werden können. Ein weiterer Vorteil besteht darin, daß eine zuverlässige Übertragung der verschiedenen Werte durch die binärkodierten Zahlen in der zyklischen Impulsfolge auf der Informationsleitung sowie eine hohe Informationsdichte erreicht wird. Außerdem können bei dieser Lösung in vorteilhafter Weiee sowohl für die zentrale Steuerlogik als auch für die dezentralen Steuermodule preisgünstige Mikrocomputer mit relativ kleinen Festwertspeichern verwendet werden. Die Mikrocomputer können dabei mehrere Alternativprogramme enthalten, von denen das richtige Programm beim Einbau der Schaltungsanordnung individuell zu dem jeweiligen Fahrzeugtyp ausgewahlt wird.

Durch die in den anhängigen Ansprüchen aufgeführten Maßnahmen sind vorteilhafte Weiterbildungen und Verbesserungen der im unabhängigen Anspruch angegebenen Merkmale gegeben. Eine besonders einfache und zuverlässige Übertragung der von den Sensoren Bemessenen Zustandsgrößen ist dadurch möglich, daß auf die Informationsleitung eine zyklische Folge von Impulsen gegeben wird, deren unterschiedliche Abstände voneinander als 0 bzw. 1-Signal die gemessenen Werte der Zustandsgrößen als Zahlen im BCD-Code darstellen.

**Zeichnung**

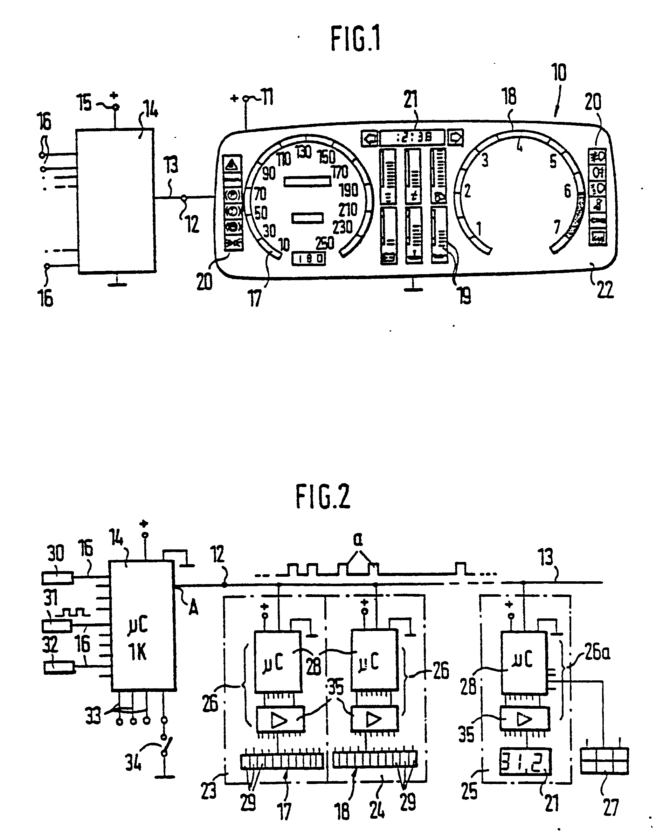

Ein Ausführungsbeispiel der Erfindung ist in der Zeichnung dargestellt und in der nachfolgenden Beschreibung näher erläutert. Es zeigen Figur 1 die erfindungsgemäße Schaltungsanordnung in systematischer Darstellung mit einer Cockpitanzeige eines Kraftfahrzeuges und einer separat davon angeordneten Steuerlogik für den Anschluß der

2

Sensoren, Figur 2 ein Blockschaltbild mit der zentralen Steuerlogik und den über die Informationsleitung damit verbundenen dezentralen Steuermodulen, Figur 3 zeigt ein Flußdiagramm der zentralen Steuerlogik zur Erfassung und Anzeige der Motordrehzahl, Figur 4 zeigt die zyklische Impulsfolge auf der Informationsleitung, Figur 5 zeigt einen Anzeigemodul für die Motordrehzahl und Figur 6 zeigt ein Flußdiagramm des Steuermoduls zur Erfassung und Verarbeitung des Drehzahlwertes.

**Beschreibung des Ausführungsbeispieles**

Figur 1 zeigt eine Cockpitanzeige 10, die in mehrere, auswechselbare Anzeigemodule aus LCD-Anzeigeelementen besteht. Die Cockpitanzeige 10 liegt einerseits auf Masse und ist andererseits über Klemme 11 an eine Gleichspannungsversorgung angeschlossen. Sie ist ferner mit Klemme 12 an eine Informationsleitung 13 angeschlossen, die von einer zentralen Steuerlogik 14 ausgeht. Die Steuerlogik 14 ist ebenfalls mit Masse und über Klemme 15 mit einer Gleichspannungsversorgung verbunden. Sie hat eine Vielzahl von Eingängen 16, an welche Sensoren angeschlossen werden, die die verschiedenen, auf der Cockpitanzeige 10 abzulesenden Zustandsgrößen im Kraftfahrzeug messen. Die Anzeigemodule der Cockpitanzeige 10 umfassen eine Geschwindigkeitsanzeige 17, eine Drehzahlanzeige 18, eine Überwachungsanzeige 19 für verschiedene, voneinander unabhängige Meßgrößen, eine Zustandsanzeige 20 für verschiedene Beleuchtungs- und Signalanlagen sowie eine von einem Bordcomputer gesteuerte Fahrdatenanzeige 21. Die verschiedenen Anzeigemodule sind hinter einer bedruckten Anzeigescheibe 22 der Cockpitanzeige 10 angeordnet. Die Meßwerte der von den Gebern gemessenen Zustandsgrößen werden über die Eingänge 16 auf die Steuerlogik 14 gegeben. In der Steuerlogik 14 werden sie - wie weiter hinten erläutert wird - in einer zyklischen Folge digitaler Signale als binärcodierte Zahlen auf die Informationsleitung 13 gegeben. Die Meßwerte werden von dort in die den Zustandsgrößen jeweils zugeordneten Anzeigemodule eingelesen, aufbereitet und über die entsprechenden LCD-Anzeigeelemente des Cockpits 10 zur Anzeige gebracht.

In Figur 2 ist das Blockschaltbild der erfindungsgemäßen Schaltungsanordnung dargestellt. Die Geschwindigkeitsanzeige 17, die Drehzahlanzeige 18 und die Fahrdatenanzeige 21 gehören jeweils zu einem Anzeigemodul 23, 24 und 25. Weitere Anzeigemodule für die Überwachungs- und Zustandsanzeigen 19, 20 sind - nicht dargestellt - ebenfalls an die Informationsleitung 13 angeschlossen. Die Anzeigemodule enthalten jeweils einen Steuermodul 26. Der Steuermodul 26a für die Fahrdatenanzeige 21 ist ein Fahrdatenrechner, der über ein separat angeordnetes Tastenfeld 27 zu bedienen ist. Der Steuermodul 26a enthält einen Mikroprozessor 28, dessen Ausgänge über eine Treiberstufe 35 an die einzelnen LCD-Anzeigeelemente der Fahrdatenanzeige 21 angeschlossen ist. In gleicher Weise bestehen auch die übrigen Steuermodule 26 aus jeweils einen Mikrocomputer 28, dessen Ausgänge über weitere Treiberstufen 35 mit den ihnen zugeordneten LCD-Anzeigeelementen 29 verbunden sind. Die zentrale Steuerlogik 14 besteht aus einem weiteren Mikrocomputer mit einem 1Kbit-EPROM-Festwert-speicher. An den Ausgängen des Mikrocomputers 14 ist eine Vielzahl von Sensoren des Kraftfahrzeuges angeschlossen, welche die anzuzeigenden Zustandsgrößen messen und von denen drei Sensoren 30, 31, 32 dargestellt sind. Die Sensoren 30, 31 und 32 geben digitale oder analoge elektrische Meßwerte über die Eingänge 16 in den Mikrocomputer 14. Alle Geber mit analogen Meßwerten werden auf solche Eingänge 16 gelegt, die einen im Mikrocomputer 14 integrierten A/D-Wandler haben. Der Mikrocomputer 14 ist außerdem noch mit mehreren Programmiereingängen 33 versehen, über die verschiedene, in seinem Festwertspeicher abgelegte Programme und Umrechnungstabellen ausgewählt werden können. Durch diese Programmiereingänge 33 können Zylinderzahl der Brennkraftmaschine, Übersetzungsverhältnis der Getriebestufen sowie die Reihenfolge der seriell ausgegebenen Anzeigedaten für verschiedene Fahrzeugtypen erfaßt und beim Einbau der Schaltungsanordnung im Fahrzeug entsprechend eingegeben werden. Über einen der Programmiereingänge 33 kann außerdem durch eine Prüftaste 34 ein Prüfprogramm aufgerufen werden, der die Funktionen des Mikrocomputers 14 prüft und bei einem Defekt ein entsprechendes Signal auf die Informationsleitung 13 oder auf eine zusätzliche Anzeige gibt.

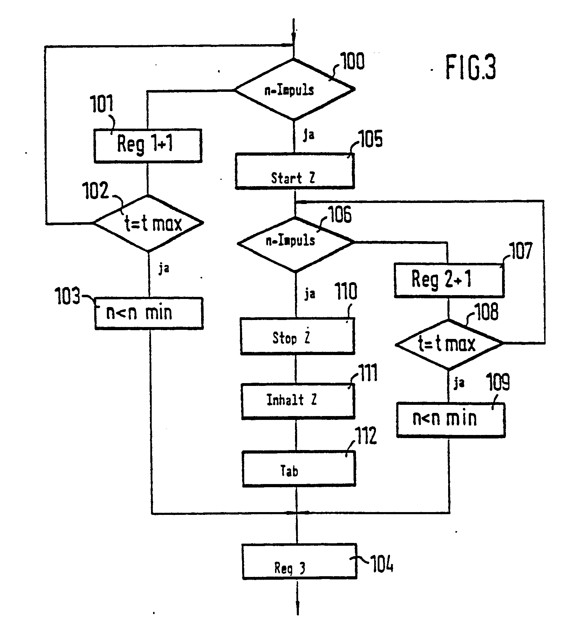

Mit Hilfe des in Figur 3 dargestellten Flußdiagrammes zur Messung der Motordrehzahl $n$ soll die Ein- und Ausgabe der von den verschiedenen Sensoren 30, 31, 32 gemessenen Zustandsgrößen durch den Mikrocomputer 14 näher erläutert werden. Das Flußdiagramm zeigt dabei den Ausschnitt aus dem gesamten Programm des Mikroprozessors 14, der speziell zur Drehzahlmessung dient.

In einem ersten Programmschritt 100 wird der für die Drehzahl $n$ des Motors vorgesehene Sensor 31, der beispielsweise der Zündgeber für die Zündanlage der Brennkraftmaschine sein kann, abgefragt. Dieser Sensor 31 gibt in Abhängigkeit von der Motordrehzahl eine sich ändernde Impulsfrequenz ab. Ist beim Programmschritt 100 kein Drehzahlimpuls vorhanden, wird im folgenden Programmschritt 101 ein Zählregister 1 um die Zahl 1 erhöht. Im folgenden Programmschritt 102 wird geprüft, ob das Zählregister 1 einen vorgegebenen Maximalwert erreicht hat. Falls das nicht der Fall ist, werden die Programmschritte 100, 101 und 102 so oft durchlaufen, bis dieser Wert erreicht ist. Danach wird im Programmschritt 103 der Drehzahlwert Null ausgegeben; was bedeutet, daß der Motor stillsteht. Dieser Drehzahlwert Null wird nun in einem weiteren Schritt 104 in ein Ausgangsregister 3 abgelegt. Mit dem nachfolgenden Programmabschnitt kann nun der nächste Sensor abgefragt werden. Tritt dagegen im Programmschritt 100 am Drehzahlsensor 31 ein Impuls auf, so wird im Programmschritt 105 ein Drehzahlzähler gestartet. Im Schritt 106 wird nun geprüft, ob vom Drehzahlsensor 31 ein weiterer. Impuls eingegangen ist. Ist das nicht der Fall, wird im Programmschritt 107 ein Zählregister 2 um die Zahl 1 erhöht und im Schritt 108 wird der Stand dieses Zählregisters 2 überprüft. Auch hier wird die Programmschleife mit den Schritten 106, 107 und 108 wiederholt durchlaufen und beim Erreichen eines vorbestimmten Zählerstandes im Zählregister 2 wird im Programmschritt 108 ein Mindestwert 1 ausgegeben, der anzeigt, daß der Motor die gewünschte Leerlaufdrehzahl nicht überschritten hat. Tritt jedoch beim wiederholten Durchlauf der Programmschleife 106, 107 und 108 ein erneuter Drehzahlimpuls auf, so wird im Schritt 110 der Drehzahlzähler gestoppt. Im Schritt 111 wird der Stand des Drehzahlzählers abgelesen. Er gibt an, welche Zeit zwischen zwei aufeinanderfolgenden Drehzahlimpulsen vergangen ist. Der Zählerstand ist dabei unmittelbar umgekehrt proportional zur Motordrehzahl $\underline{n}$. Im Programmschritt 112 wird nun unter Berücksichtigung der an einem Programmiereingang 33 eingegebenen Zylinderzahl aus dem Festwertspeicher ein Tabellenwert für die ermittelte Drehzahl $\underline{n}$ ausgelesen. Dieser Tabellenwert wird nun im nachfolgenden Schritt 104 in das Ausgangsregister 3 abgelegt. In ähnlicher Weise werden nun sämtliche Signale der angeschlossenen Sensoren verarbeitet und die ermittelten Tabellenwerte werden in entsprechende Ausgangsregister 3 abgelegt.

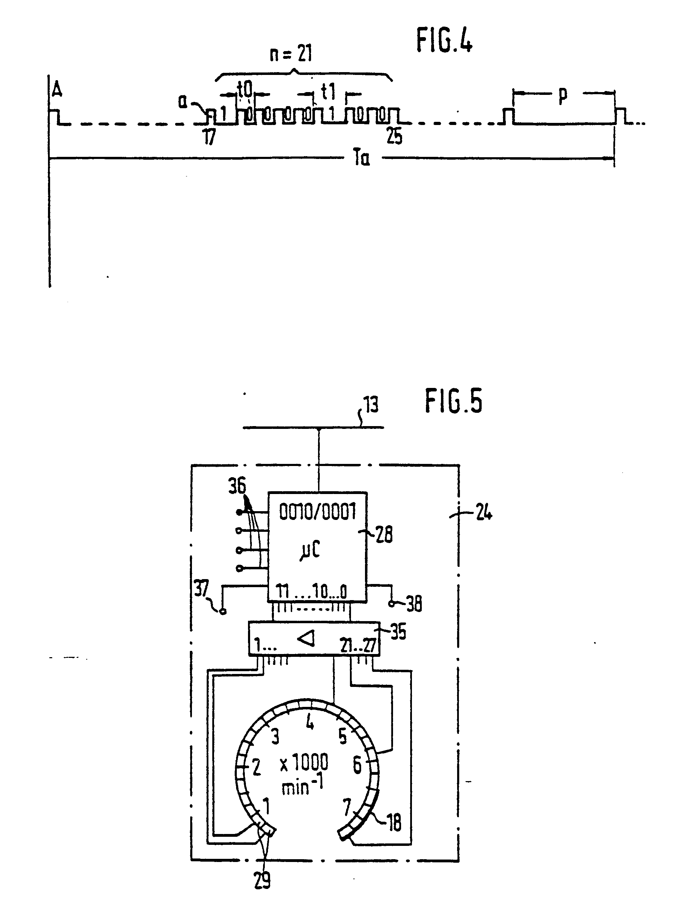

In einem späteren, nicht dargestellten Programmabschnitt werden die in den Ausgangsregistern abgelegten Zahlenwerte in einer zyklischen Signalfolge als binärkodierte Zahlen auf die Informationsleitung 13 gegeben. Die Reihenfolge der auf diese Weise vom Mikrocomputer 14 aufbereiteten Meßdaten ist dabei durch eine entsprechende Programmierung an den Programmiereingängen 33 vorgegeben. Die Signalfolge wird dabei am Ausgang des Mikrocomputers 14 als eine Folge von elektrischen Impulsen $\underline{a}$ auf die Informationsleitung 13 gegeben. In Figur 4 ist eine solche, am Ausgang A des Mikrocomputers 14 erscheinende zyklische Signalfolge mit binärkodierten Zahlen dargestellt. Sie besteht in dem Beispielsfall aus einer Impulsfolge Ta von 256 Impulsen $\underline{a}$ mit einer Impulsbreite von 20 µs.

Gegen Ende der Impulsfolge Ta tritt eine Synchronisationspause $\underline{p}$ auf, durch die sämtliche Steuermodule 26 zurückgesetzt werden. Durch unterschiedliche Abstände der aufeinanderfolgenden Impulse $\underline{a}$ werden die vom Mikroprozessor 14 ermittelten, in seinen Ausgangsregistern abgelegten Werte im BCD-Code als 0- bzw. 1-Signale auf die Informationsleitung 13 gegeben. Der kleine Abstand hat dabei den Wert 0 und der größere Abstand hat den Wert 1. Der Taktabstand $\underline{to}$ zweier Impulse $\underline{a}$ mit dem Wert 0 beträgt $\overline{200}$ µs und der Taktabstand $\underline{t1}$ mit dem Wert 1 beträgt 400 µs. Die Impulsfolge Ta wird in 100 ms durchlaufen, so daß in jeder Sekunde 10 Impulszyklen auftreten.

Im Beispielsfall soll eine Motordrehzahl $\underline{n}$ von 6000 min$^{-1}$ vom Sensor 31 gemessen und von der Drehzahlanzeige 18 angezeigt werden. Figur 5 zeigt den dafür vorgesehenen Anzeigemodul 24. Die Drehzahlanzeige 18 ist als ringförmige Skala ausgebildet und in 27 LCD-Anzeigeelemente 29 unterteilt. Um die Drehzahl 6000 anzuzeigen, müssen die ersten 21 LCD-Anzeigeelemente 29 angesteuert werden. Dies wird nun dadurch erreicht, daß aus dem Festwertspeicher des zentralen Mikroprozessors 14 bei der vom Sensor 31 gemessenen Drehzahl von 6000 min$^{-1}$ der Wert 21 im BCD-Code in die entsprechenden Ausgangsregister abgelegt wird (Schritt 104, Figur 3). Von dort wird der Wert 21 im Beispielsfall zwischen demsiebzehnten und fünfundzwanzigsten Impuls $\underline{a}$ durch entsprechende Impulspausen ebenfalls im BCD-Code auf die Informationsleitung 13 gegeben. Der Mikrocomputer 28 des Anzeigemoduls 24 für die Drehzahlanzeige erfaßt sowohl die Impulse $\underline{a}$ als auch die Impulspausen. Durch eine Zeitschleife im Programm des Mikrocomputers 28 wird festgestellt, ob der jeweilige Impulsabstand den Wert 0 oder den Wert 1 hat bzw. ob eine Synchronisationspause $\underline{p}$ vorliegt. Die 0- und 1-Signale werden kontinuierlich in ein 8 bit-Schieberegister des Mikrocomputers 28 eingelesen. Außerdem werden die Impulse $\underline{a}$ in einem Zählregister des Mikrocomputers 28 gezählt, der durch eine Pin-Programmierung des Mikrocomputers 28 auf eine bestimmte Zahl eingestellt ist. Da nun der zentrale Mikrocomputer 14 zwischen dem 17. und 25. Impuls $\underline{a}$ den Drehzahlwert 21 im BCD-Code auf die Informationsleitung 13 gibt, ist dieser Wert mit dem 25. Impuls $\underline{a}$ im Mikrocomputer 28 gespeichert. Dieser gespeicherte Wert wird nun durch den Mikrocomputer 28 dekodiert und über entsprechende Umrechnungstabellen, welche in seinem Festwertspeicher abgelegt sind, werden seine Ausgange aktiviert. Dabei werden die Ausgänge 1 bis 21 mit einem 1-Signal belegt und die Ausgänge 22 bis 27 mit einem 0-Signal. Über die nachgeschaltete Treiberstufe 35 werden nun die ersten 21 LCD-Anzeigeelemente 29 aktiviert und dadurch die Motordrehzahl 6000 min$^{-1}$ angezeigt.

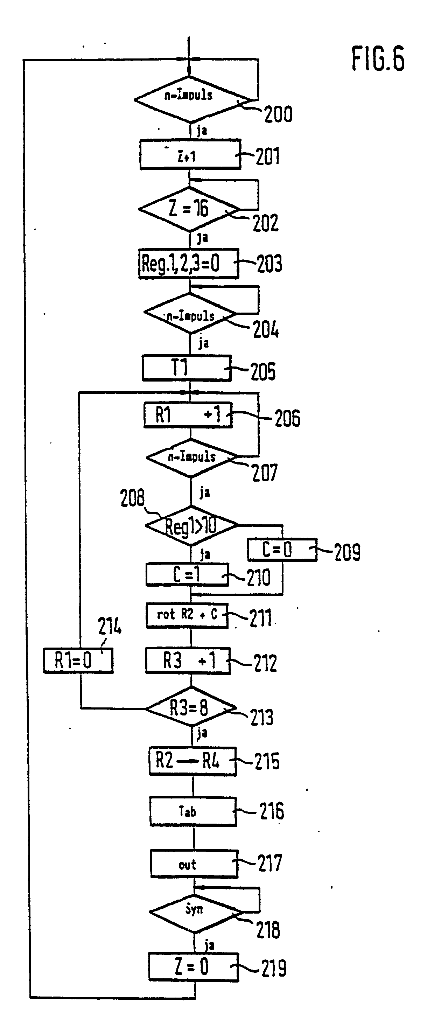

In Figur 6 ist ein Programm dargestellt, mit dem der Mikrocomputer 28 in Figur 5 die für ihn bestimmte Information für die Motordrehzahl $n$ aus der in Figur dargestellten Impulsfolge Ta herausliest. Im ersten Programmschritt 200 prüft der Mikrocomputer 28, ob auf der Informationsleitung 13 ein Impuls $a$ vorhanden ist. Sobald ein solcher Impuls $a$ auftritt, wird das Zählregister im Schritt 201 um die Zahl 1 erhöht. Im nächsten Programmschritt 202 wird der Zählerstand geprüft. Mit dem 16. Impuls $a$ erreicht das Zählregister die Zahl 16 und mit dem folgenden Programmschritt 203 werden mehrere Register R1, R2, R3 auf 0 gesetzt und damit zum Einlesen der gewünschten Drehzahlinformation vorbereitet. Im folgenden Schritt 204 wird nun der nachfolgende 17. Impuls $a$ abgewartet. Sobald er auftritt, wird im folgenden Schritt 205 eine vorgegebene Zeit T1 von beispielsweise 50 µs abgearbeitet. Danach wird im Schritt 206 ein Register R1 von 0 auf die Zahl 1 erhöht und anschließend wird im Schritt 207 geprüft, ob ein weiterer Impuls $a$ aufgetreten ist. Ist dies noch nicht der Fall, so wird das Register R1 inkrementiert. Diese Schleife mit den Programmschritten 206 und 207 wird so oft durchlaufen, bis der 18. Impuls $a$ auftritt. Durch die im Register R1 stehende Zahl der Durchläufe kann nun geprüft werden, ob die Taktzeit zwischen zwei aufeinanderfolgenden Impulsen $a$ gemäß Figur 4 die Zeit $t0$ oder die Zeit $t1$ ist. Bei einer Taktzeit $t0$, die den Informationswert 0 darstellt, hat das Register R1 beispielsweise den Inhalt 10. Bei einer Taktzeit $t1$, welche den Informationswert 1 darstellt, wird dagegen das Register R1 bis auf den Wert 30 inkrementiert. Im nachfolgenden Programmschritt 208 wird nun geprüft, ob der Inhalt des Registers R1 größer als 10 ist. Ist dies nicht der Fall, so wurde ein Taktabstand $t0$ mit dem Wert 0 ermittelt und im Programmschritt 209 wird nun das Carry-Register auf 0 gesetzt. Ist dagegen der Inhalt des Registers R1 größer als 10, so wurde ein Taktabstand $t1$ mit dem Informationswert 1 ermittelt und das Carry-Register wird im Schritt 210 auf 1 gesetzt. Im nachfolgenden Programmschritt 211 wird ein Register R2 zusammen mit dem Carry-Register um einen Schritt rotiert und damit wird der erste Wert aus der Drehzahlinformation der Impulsfolge Ta in die erste Stelle des Registers R2 gerückt. Im folgenden Schritt 212 wird ein weiteres Register R3 um 1 erhöht. Im Schritt 213 wird nun geprüft, ob das Register R3 auf den Wert 8 gestellt wurde. Solange dies nicht der Fall ist, wird in einem weiteren Programmschritt 214 das Register R1 wieder auf Null zurückgesetzt und die Schritte 206 und 207 werden nun erneut zyklisch durchlaufen, bis der nächste Impuls $a$ auftritt.

Auf diese Weise werden nun die durch die Taktabstände $t0$ und $t1$ der Impulsfolge Ta dargestellten Informationswerte zwischen dem 17. und 25. Impuls $a$ ermittelt und im Register R2 eingespeichert. Mit dem 25. Impuls $a$ erreicht das Register R3 im Programmschritt 212 den Wert 8. Im nachfolgenden Schritt 215 wird nun der Inhalt des Registers R2 in ein weiteres Register R4 umgespeichert und im Schritt 216 wird nun über die im Register R4 abgespeicherte Drehzahlinformation aus einer ROM-Tabelle ein Wert abgerufen, der im Programmschritt 217 zur Ansteuerung der entsprechenden Anzeigeelemente 29 als 0- und 1-Signale auf die 27 Ausgänge des Mikrocomputer 28 gelangt. Im Schritt 218 wird nun die Synchronisationspause $p$ abgewartet und im Schritt 219 wird das Zählregister auf 0 zurückgesetzt. Danach springt das Programm wieder auf den Schritt 200 zurück und die Motordrehzahl wird mit der nachfolgenden Impulsfolge Ta erneut in das Anzeigemodul 24 eingelesen.

Da zur Drehzahlanzeige nur 27 LCD-Anzeigeelemente benötigt werden, bleiben die zwei vorderen Stellen der vorderen BCD-Zahl frei. Sie können daher bei entsprechender Programmierung des zentralen Mikrocomputers 14 und des Mikrocomputers 28 im Anzeigemodul 24 für weitere Anzeigewerte, beispielsweise für die Überwachung bestimmter Glühlampen verwendet werden.

Der Mikrocomputer 28 ist außerdem mit weiteren Eingängen 36 versehen, auf denen der anzuzeigende Wert gegebenenfalls auch in einer parallelen Dateneingabe übermittelt werden kann. Über einen Programmiereingang 37 wird in diesem Fall festgelegt, ob die über die Informationsleitung 13 in dem Mikrocomputer 28 gelangende serielle Dateneingabe oder die über die Eingänge 36 gelangende parallele Dateneingabe ausgewertet werden soll. Außerdem ist es auch möglich, zusätzlich zur seriellen Dateneingabe über die Informationsleitung 13 bestimmte Signalgeber unmittelbar über die Eingänge 36 an den Mikrocomputer 28 anzuschließen und dessen Signale mit zu verarbeiten. Ferner kann über einen weiteren Programmiereingang 38 der Mikrocomputer 28 mit einem Prüfprogramm getestet werden.

Der Mikrocomputer 28 für die Fahrdatenanzeige 21 muß als Fahrdatenrechner arbeiten und bei entsprechender Betätigung des Tastenfeldes 27 Fahrzeit, Benzinverbrauch, Durchschnittsgeschwindigkeit und dgl. berechnen können. Außerdem soll er immer dann die Uhrzeit anzeigen, wenn keine Fahrdaten abgerufen werden. Zur Ermittlung der jeweils gewünschten Fahrdaten benötigt er verschiedene, vom zentralen Mikrocomputer 14 ausgegebene Werte. Um diese Werte aus der zyklischen Signalfolge auf der Informationsleitung 13 herauszulesen, müssen mehrere Programmabschnitte gemäß Figur 6 durchlaufen und dabei das Zählregister jeweils so umgeschaltet werden, daß er alle zur Berechnung der Fahrdaten benötigten Werte aus der zyklischen Signalfolge auslesen und mit einem internen Programm verarbeiten kann.

Die Erfindung ist nicht auf das dargestellte Ausführungsbeispiel beschränkt. So ist es ohne weiteres möglich, die auf der Informationsleitung 13 zu übertragenden Daten als eine Folge von 0- bzw. 1-Signalen im einfachen Binärcode oder in einem 1 aus n-Code zu übertragen. Die 0- oder 1-Signale können dabei auch durch unterschiedlich breite Impulse a übertragen werden, wobei dann alle Impulspausen mit Ausnahme der Synchronisationspause p gleich sind. Erfindungswesentlich ist jedoch, daß die zentrale Steuerlogik 14 eine zyklische Signalfolge von binärkodierten Zahlen auf die Informationsleitung 13 gibt, welche den Werten entsprechen, die von den verschiedenen Sensoren ermittelt werden. Wesentlich ist ferner, daß jeder Steuermodul einen Impulszähler und eine Dekodierstufe enthält, die gemäß Figur 6 durch ein μ C-Programm realisiert sein können. Der Zähler wählt die dem Steuermodul zugeordneten binärkodierten Zahlen aus der zyklischen Signalfolge aus und die Dekodierstufe setzt diese Binärzahlen in 1- bzw. 0-Signale um. Durch diese Signale werden nun die Anzeigeelemente 29 angesteuert, welche die von den Gebern gemessenen Werte wiedergeben. Dabei können anstelle von LCD-Anzeigeelementen 29 auch Leuchtdioden, Vakuum-Fluoreszenz-Displays oder andere aktive, quasiaktive oder nichtaktive Anzeigeelemente verwendet werden. Üblicherweise ist die Informationsleitung 13 eine Kupferleitung und die zyklische Signalfolge wird durch elektrische Impulse a übertragen. Im Rahmen der Erfindung ist es aber auch möglich, die Informationsleitung 13 als Glasfaser weiter auszubilden, auf den die ermittelten Daten in einer zyklischen Folge von Lichtimpulsen übertragen werden.

Durch die Verwendung einer intelligenten Steuerung in den Steuermodulen ist es möglich, die zentrale Steuerlogik in einem Mikrocomputer mit relativ kleinem Speicher zu realisieren. Die Weiterverarbeitung der übermittelten Daten erfolgt dabei in den intelligenten Steuerungen der Steuermodule 26. Bei einem Defekt können so mit geringem Reparaturaufwand einzelne Module ausgewechselt werden. Die Aufgliederung der vollständigen Cockpit-Anzeige 10 in einzelne Steuer- und Anzeigemodule wird dabei zweckmäßigerweise so gewählt, daß die kostenintensiven Baugruppen voneinander und von den übrigen Teilen der Cockpit-Anzeige zu trennen sind. Dabei kann es unter Umständen zweckmäßig sein, die kostenintensiven Anzeige-Displays so aufzugliedern, daß mehrere Displayplatinen an ein und demselben Steuermodul angeschlossen werden. Steuermodule und Anzeige-Displays sind miteinander lösbar verbunden und voneinander getrennt auswechselbar.

Um möglichst wenig lösbare Kontaktstellen zu bekommen, ist es zweckmäßig, wenn jeder Steuermodul mit den ihm zugeordneten Anzeigeelementen fest verbunden als auswechselbarer Anzeigemodul ausgebildet ist.

Bei der in Figur 2 dargestellten Ausführung der erfindungsgemäßen Schaltungsanordnung wird beispielsweise für die zentrale Steuerlogik 14 der Mikrocomputer 8748 der Firma Intel und für die Steuermodule 26 der Mikrocomputer 6805 der Firma Motorola verwendet.

## Patentansprüche

1. Schaltungsanordnung für eine optische Anzeige von Zustandsgrößen im Kraftfahrzeug durch optoelektrische Anzeigeelemente (21, 29), die über Steuermodule (26, 26a) blockweise zusammengefaßt und über eine gemeinsame Informationsleitung (13) an eine Kodier-Steuerlogik (14) angeschlossen sind, die mit Sensoren (30, 31, 32) verbunden ist, welche die Zustandsgrößen messen, wobei die gemessenen Werte der Zustandsgrößen über die Kodier-Steuerlogik in einer seriellen Impulsfolge (Ta) von digitalen Signalen mit einem Synchronsignal auf die Informationsleitung gegeben werden, in der die Steuermodule jeweils einen Impulszähler und eine Dekodierstufe enthalten, welche die den Steuermodul zugeordneten Impulse und die zu übermittelnden Werte aus der Signalfolge auswählen und die Werte an den Anzeigeelementen zur Anzeige bringen, dadurch gekennzeichnet,

a) daß die Kodier-Steuerlogik eine zentrale Steuerlogik (14) ist, an welche die Sensoren (30, 31, 32) für die verschiedenen, auf der Anzeige (10) abzulesenden Informationen angeschlossen sind,

b) daß die serielle Impulsfolge (Ta) der digitalen Signale als zyklische Folge aus einer bestimmten Anzahl von Taktimpulsen (a) besteht, deren unterschiedliche Taktabstände (t0, t1) in je einem festgelegten, eine bestimmte Impulszahl aufweisenden Impulsfolgeabschnitt die zu übertragenden Meßwerte in Form von binärkodierten Zahlen (n) darstellen,

c) daß die Impulsfolgeabschnitte von den ihnen zugeordneten Steuermodulen (26, 26a) durch einen entsprechend adressierten Zähler zu erfassen sind und die darin enthaltenen binärkodierten Zahlen (n) in die Dekodierstufe des entsprechenden Steuermoduls (26, 26a) gelangen,

d) daß die Zähler der Steuermodule (26) vor Beginn einer neuen Impulsfolge (Ta) durch ein Synchronsignal (p) zurücksetzbar sind und

e) daß die Dekodierstufe die binärkodierte Zahl in Steuersignale umsetzt, welche die den gemessenen Werten zugeordneten Anzeigeelemente (21, 29) ansteuern.

2. Schaltungsanordnung nach Anspruch 1, dadurch gekennzeichnet, daß zur Erzeugung der zyklischen Signalfolge die zentrale Steuerlogik (14) aus einem Mikrocomputer mit einem Festwertspeicher besteht, der Umrechnungstabellen für die Umwandlung der von den Sensoren (30, 31, 32) gemessenen Werte in die binärkodierten Zahlen enthält.

3. Schaltungsanordmung nach Anspruch 2, dadurch gekennzeichnet, daß zur Anzeige der gemessenen Werte an den ihnen zugeordneten Anzeigeelementen (21, 29) jeder Steuermodul (26, 26a) aus einem Mikrocomputer mit einem Festwertspeicher besteht, der eine Umrechnungstabelle für die Umwandlung der von ihm erfasten binärkodierten Zahlen (n) aus der zyklischen Signalfolge in Signale zur Ansteuerung der Anzeigeelemente (21, 29) enthält.

4. Schaltungsanordnung nach Anspruch 3, dadurch gekennzeichnet, daß die binärkodierten Zahlen für die in der zyklischen Impulsfolge (Ta) auf der Informationsleitung (13) zu übertragenden Werte als 0- bzw. 1-Signale dargestellt sind, und von den Steuermodulen (26, 26a) erfaßt werden.

5. Schaltungsanordnung nach Anspruch 4, dadurch gekennzeichnet, daß die 0- bzw. 1-Signale die binärkodierten zahlen im BCD-code darstellen.

6. Schaltungsanordnung nach Anspruch 4, dadurch gekennzeichnet, daß die Zähler der Steuermodule (26, 26a) durch eine zwischen zwei Signalfolgen liegende größere Impulspause (p) zurücksetzbar sind.

7. Schaltungsanordnung nach Anspruch 5, dadurch gekennzeichnet, daß jeder Steuermodul (26, 26a) für sich auswechselbar und mit mindestens einem die Anzeigeelemente (21, 29) enthaltenden, ebenfalls für sich auswechselbaren Anzeige-Display lösbar verbunden ist.


**Revendications**

1. Dispositif de circuit pour un affichage optique de grandeurs caractéristiques dans des véhicules automobiles, par des éléments opto-électriques d'affichage (21, 29) qui, par l'intermédiaire de modules de commande (26, 26a), sont rassemblés en blocs, et qui par l'intermédiaire d'une liaison d'information commune (13) sont raccordés à une logique de commande et de codage (14) qui est reliée à des détecteurs (30, 31, 32) qui mesurent les grandeurs caractéristiques, les valeurs ainsi mesurées des grandeurs caractéristiqués étant délivrées à la liaison d'information par l'intermédiaire de la logique de commande et de codage, selon une succession d'impulsions en série (Ta) de signaux numériques avec un signal de synchronisation, les modules de commande comportant respectivement un compteur d'impulsions et un étage de décodage, qui sélectionnent à partir de la succession de signaux les impulsions associées aux modules de commande et les valeurs à transmettre, et qui appliquent ces valeurs pour l'affichage aux éléments d'affichage, dispositif de circuit caractérisé en ce que:

a) la logique de commande et de codage est une logique centrale de commande (14) à laquelle sont raccordés des détecteurs (30, 31, 32) pour les différentes informations à lire sur l'affichage (10),

b) la succession d'impulsions en série (Ta) des signaux numériques est constituée sous la forme d'une succession cyclique d'un nombre déterminé d'impulsions (a) dont les différents intervalles de cycles (t0, t1) représentent respectivement dans une partie de succession d'impulsions définie comportant un nombre d'impulsions déterminé, les valeurs de mesure à transmettre sous la forme de chiffres (n) codés en binaire,

c) les parties de successions d'impulsions sont captées par les modules de commande (26, 26a) qui leur sont associés grâce à un compteur adressé de façon correspondante et les chiffres (n) codés en binaire qui y sont contenus arrivent dans les étages de décodage du module de commande correspondant (26, 26a).

d) les compteurs des modules de commande (26) sont remis à zéro dans le début d'une nouvelle succession d'impulsions (Ta) par un signal de synchronisation (p),

e) l'étage de décodage transforme les nombres codés en binaire en signaux de commande qui commandent les éléments d'affichage (21, 29) associés aux valeurs mesurées.

2. Dispositif de circuit selon la revendication 1, caractérisé en ce que, pour obtenir la succession cyclique de signaux, la logique centrale de commande (14) est constituée d'un microcalculateur avec une mémoire de valeur fixe, qui contient des tableaux de calculs pour la transformation des valeurs mesurées par les détecteurs (30, 31, 32) en chiffres codés en binaire.

3. Dispositif de circuit selon la revendication 2, caractérisé en ce que, pour l'affichage des valeurs mesurées sur les éléments d'affichage (21, 29) qui leur sont associés, chaque module de commande (26, 26a) est constitué par un microcalculateur avec une mémoire de valeur fixe, qui comprend un tableau de calculs pour la transformation des chiffres (n) codés en binaire captés par ce module, à partir de la succession cyclique de signaux en signaux pour la commande des éléments d'affichage (21, 29).

4. Dispositif de circuit selon la revendication 3, caractérisé en ce que les chiffres codés en binaire pour les valeurs à transmettre dans les successions cycliques d'impulsions (Ta) sur la liaison d'information (13), sont constitués sous la forme de signaux 0 ou bien 1, et sont détectés par les modules de commande (26; 26a).

5. Dispositif de circuit selon la revendication 4, caractérisé en ce que les signaux 0 ou bien 1 représentent en code BCD les chiffres codés en binaire.

6. Dispositif de circuit selon la revendication 4, caractérisé en ce que les compteurs des modules de commande (26, 26a) sont susceptibles d'être remis à l'état initial par une pause d'impulsion plus importante (p) se situant entre deux succesions de signaux,

7. Dispositif de circuit selon la revendication 5, caractérisé en ce que chaque module de commande (26, 26a) est en soi interchangeable,

**0 120 196**

et est relié de façon amovible avec au moins ur affichage également en soi interchangeable contenant les éléments d'affichage (21, 29).

## Claims

1. Circuit arrangement for an optical display of state variables in a motor vehicle by means of optoelectric display elements (21, 29) which are combined in blocks via control modules (26, 26a) and are connected via a common information line (13) to a coding control logic (14) which is connected to sensors (30, 31, 32) which measure the state variables, in which arrangement the measured values of the state variables are passed via the coding control logic in a serial pulse sequence (Ta) of digital signals with a synchronising signal to the information line, in which arrangement the control modules contain in each case one pulse counter and one decoding stage which select the pulses associated with the control module and the values to be transmitted from the signal sequence and display the values on the display elements, characterized in that

a) the coding control logic is a central control logic (14) to which the sensors (30, 31, 32) for the various information items to be read off the display (10) are connected,

b) the serial pulse sequence (Ta) of the digital signals, as a cyclic sequence, consists of a particular number of clock pulses (a), the different clock pulse intervals (t0, t1) of which represent, in one determined pulse sequence section each which has a particular number of pulses, the measurement values to be transferred, in the form of binary coded numbers (n),

c) the pulse sequence sections of the control modules (26, 26a) associated with them must be detected by an appropriately addressed counter and the binary coded numbers (n) contained in them reach the decoding stage of the corresponding control module (26, 26a),

d) that the counters of the control modules (26) are resettable by a synchronising signal (p) before the beginning of a new pulse sequence (Ta) and

e) that the decoding stage converts the binary coded number into control signals which drive the display elements (21, 29) associated with the measured values.

2. Circuit arrangement according to Claim 1, characterized in that, for generating the cyclic signal sequence, the central control logic (14) consists of a micro-computer containing a read-only memory which contains conversion tables for converting the values measured by the sensors (30, 31, 32) into the binary coded numbers.

3. Circuit arrangement according to Claim 2, characterized in that, for displaying the measured values at the display elements (21, 29) associated with them, each control module (26, 26a) consists of a microcomputer containing a read-only memory which contains a conversion table for converting the binary coded numbers (n) detected by it from the cyclic signal sequence into signals for driving the display elements (21, 29).

4. Circuit arrangement according to Claim 3, characterized in that the binary coded numbers for the values to be transmitted in the cyclic pulse sequence (Ta) on the information line (13) are represented as 0 or 1 signals and are detected by the control modules (26, 26a).

5. Circuit arrangement according to Claim 4, characterized in that the 0 or 1 signals represent the binarycoded numbers in BCD code.

6. Circuit arrangement according to Claim 4, characterized in that the counters of the control modules (26, 26a) are resettable by a relatively large pulse interval (p) located between two signal sequences.

7. Circuit arrangement according to Claim 5, characterized in that each control module (26, 26a) is separately exchangeable and is detachably connected to at least one display module which contains the display elements (21, 29) and which is also separately exchangeable.

# FIG.1

# FIG.2

FIG.3

```
                    ┌─────────────┐
                    │             │
                 ╱──┴──╲  100
              ╱─         ─╲
             │  n-Impuls    │
              ╲─         ─╱
    101         ╲──┬──╱
  ┌──────────┐      │ ja
  │ Reg 1+1  │   ┌──┴─────┐  105
  └────┬─────┘   │ Start Z │
 102   │         └────┬────┘
    ╱──┴──╲            │
  ╱  t=t max ╲      ╱──┴──╲  106
  ╲         ╱    ╱  n-Impuls ╲──────────┐
    ╲──┬──╱      ╲         ╱             │
       │ ja        ╲──┬──╱          ┌────┴────┐ 107
 103 ┌─┴──────┐       │ ja  110     │ Reg 2+1 │
     │ n<n min│   ┌───┴────┐        └────┬────┘
     └────────┘   │ Stop Z │       108   │
                  └───┬────┘       ╱──────┴──╲
                  111 │          ╱  t=t max   ╲──┐
                  ┌───┴────┐     ╲           ╱   │
                  │Inhalt Z│       ╲──┬──╱       │
                  └───┬────┘          │ ja 109   │
                  112 │           ┌───┴────┐     │
                  ┌───┴────┐      │ n<n min│     │
                  │  Tab   │      └────────┘     │
                  └───┬────┘                     │
                      │                          │
               ┌──────┴──────┐                   │
               │    Reg 3    │  104               │
               └──────┬──────┘                    │
                      │
```

## FIG.4

## FIG.5

FIG.6

n-Impuls — 200
ja
Z+1 — 201
Z = 16 — 202
ja
Reg.1,2,3=0 — 203
n-Impuls — 204
ja
T1 — 205
R1    +1 — 206
n-Impuls — 207
ja
208 — Reg1>10
ja
C=0 — 209
C=1 — 210
rot R2 + C — 211
214 — R1=0
R3    +1 — 212
R3=8 — 213
ja
R2 → R4 — 215
Tab — 216
out — 217
Syn — 218
ja
Z = 0 — 219

7